Europäisches Patentamt

European Patent Office

Office européen des brevets

(11) Veröffentlichungsnummer: **0 176 786**
**B1**

(12) **EUROPÄISCHE PATENTSCHRIFT**

(45) Veröffentlichungstag der Patentschrift:
27.12.89

(51) Int. Cl.⁴: **H 03 H 9/145**, H 03 H 9/64

(21) Anmeldenummer: **85111041.1**

(22) Anmeldetag: **02.09.85**

(54) **Wandler für SAW-Anordnung.**

(30) Priorität: **03.09.84 CH 4318/84**

(43) Veröffentlichungstag der Anmeldung:
**09.04.86 Patentblatt 86/15**

(45) Bekanntmachung des Hinweises auf die Patenterteilung:
**27.12.89 Patentblatt 89/52**

(84) Benannte Vertragsstaaten:
**CH DE FR GB IT LI NL**

(56) Entgegenhaltungen:
**6TH EUROPEAN MICROWAVE CONFERENCE, 14.-16. September 1976, Rome, IT, Seiten 267-271, Megaron Press Ltd., Bournemouth, GB; F.M. NYFFELER: "Detailed investigation on the group-type unidirectional interdigital saw transducer with its application to low insertion loss surface wave filters"**

(73) Patentinhaber: **Epprecht, Georg, Prof., Dr., Gloriastrasse 35, CH- 8092 Zürich (CH)**

(72) Erfinder: **Ebneter, Josef, Gloriastrasse 35, CH- 8092 Zürich (CH)**

(74) Vertreter: **Mehl, Ernst, Dipl.- Ing., Postfach 22 13 17, D-8000 München 22 (DE)**

EP 0 176 786 B1

2

## Beschreibung

Die vorliegende Erfindung betrifft einen Wandler für eine SAW-Anordnung nach dem Oberbegriff des Patentanspruches 1.

SAW-Anordnungen (Surface Acoustic Waves), insbesondere SAW-Filter sind elektrische Bauelemente, die auf der Ausbreitung mechanischer bzw. akustischer Wellen in der Oberfläche eines piezoelektrischen Substrat-Plättchens beruhen. Die Umwandlung elektrischer Signale in akustische Oberflächenwellen und umgekehrt geschieht üblicherweise durch "interdigitale Wandler". Solche Wandler bestehen im einfachsten Falle aus einer Reihe auf die Substratoberfläche aufgedampfter dünner Metallstreifen, die als Fingerelektroden bezeichnet werden und die interdigital bzw. alternierend mit zwei Sammelschienen verbunden sind. Wird an die Sammelschienen eine elektrische Wechselspannung angelegt, entsteht aufgrund des piezo-elektrischen Effektes eine oberflächliche Verformung des Substrates, die sich als mechanische Welle in zwei entgegengesetzte Richtungen quer zur Längstausdehung der Fingerelektroden ausbreitet. Durch einen weiteren interdigital Wandler wird aus der mechanischen Oberflächenwelle wieder ein elektrisches Signal gewonnen. Die Übertragungsfunktion einer derart aufgebauten SAW-Anordnung kann weitgehend durch die Geometrie der beiden Wandler vorgegeben werden (d.h. durch die Anzahl der Fingerelektroden, deren Längen, Breiten, Abstände usw.). Häufig wird ein möglichst ausgeprägtes Bandpassverhalten angestrebt.

SAW-Anordnungen mit einfachen Wandlertypen (sog. bidirektionalen Wandlern) weisen beachtliche Verluste auf, einesteils weil der Sendewandler die Oberflächenwellen in zwei entgegengesetzte Richtungen abstrahlt und weil der Empfangswandler maximal die Hälfte der einfallenden Energie an eine elektrische Last abgeben kann, andernteils weil die Wandler nicht optimal an die Quelle oder Last angepasst werden dürfen, da sonst störende Reflexionen innerhalb des Wandlers (sog. Triple Transit Echoes) auftreten würden.

Die beschriebenen Filterverluste lassen sich weitgehend reduzieren, wenn Richtwandler verwendet werden, welche die akustischen Wellen im Durchlassbereich praktisch nur in eine Richtung abstrahlen. Praktische Bedeutung haben der Mehrphasen- und der Gruppen-Richtwandler (group type unidirectional transducer) erlangt. Mehrphasige Wandler sind mehrschichtig aufgebaut und daher in der Herstellung wesentlich aufwendiger als ein einlagig aufgebauter Gruppen-Richtwandler.

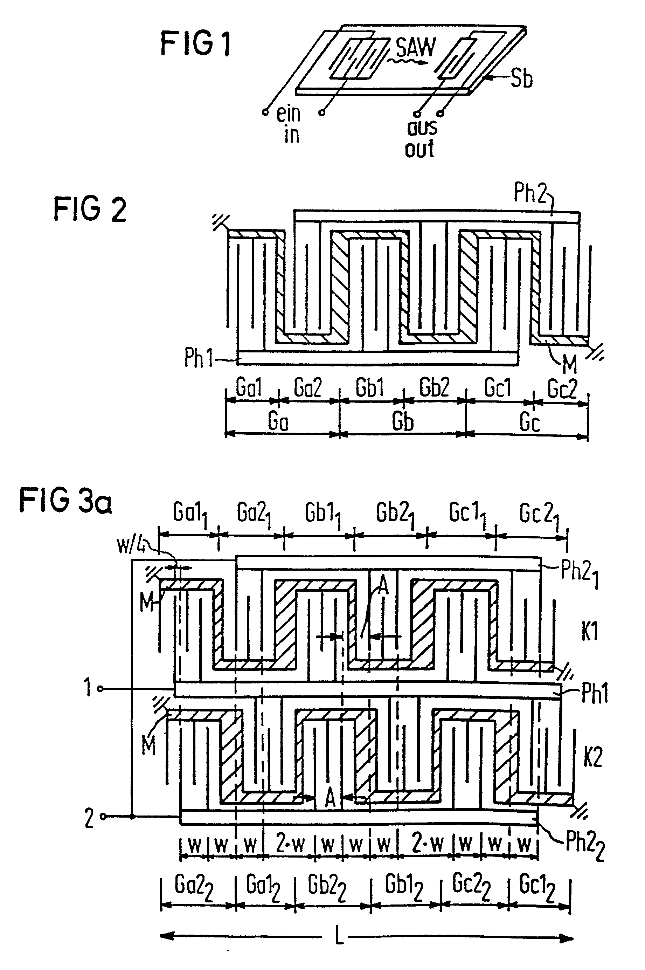

Beim Gruppen-Richtwandler vgl. z. B. 6th European Microwave Conference 14 - 16 Sept. 1976, Rome Seiten 267 - 271 werden die Fingerelektroden, wie Fig. 2 zeigt, in mehreren Gruppen Ga, Gb, Gc... angeordnet. Jede einzelne Gruppe Ga, Gb... besteht aus zwei in der Regel identischen Halbgruppen Ga1, Ga2; Gb1, Gb2;..., die um bekanntermaßen n. Lambda ± Lambda/4 gegeneinander verschoben sind. Darin ist n: eine ganze Zahl und Lambda die Wellenlänge bei der Synchronfrequenz. Dieser Wandler hat zwei Sammelschienen PH1 und PH2. Es ist eine weitere, und zwar gemeinsame, mäanderförmige Sammelschiene bzw. Erdleitung M vorgesehen, deren Verlauf im Wandler derart ist, daß diese weitere Sammelschiene benachbart liegende Halbgruppen voneinander trennt, wie dies Fig. 2 zeigt. Je nach Zugehörigkeit zur jeweils linken (Ga1, Gb1...) oder zur rechten (Ga2, Gb2...) Halbgruppe sind die "heißen" Fingerelektroden dieser Halbgruppen mit jeweils einer der beiden Sammelschienen Ph1 bzw. Ph2 verbunden. Dementsprechend wird an die eine Sammelschiene Ph1 die eine Phase des einzuspeisenden elektrischen Signals angelegt. An die andere Sammelschiene Ph2 wird die andere Phase dieses Signals angelegt, wobei diese beiden Phasen bei der Synchronfrequenz einen Phasenunterschied von 90° zueinander haben. An die weitere Sammelschiene M wird eine dritte Phase bzw. wird ein Bezugspotential, z. B. Masse angelegt. Man kann sich dementsprechend den Wandler aus zwei ineinander verschachtelten Teilwandlern zusammengesetzt denken, wobei der eine Teilwandler die Halbgruppen Ga1, Gb1, Gc1,... der andere Teilwandler die Halbgruppen Ga2, Gb2, Gc2,... umfaßt.

Die Richtwirkung dieses Richtwandlers kommt nun dadurch zustande, daß sich die Wellen der beiden Teilwandler in Vorwärtsrichtung addieren, während sie sich in der anderen Richtung auslöschen. In Vorwärtsrichtung kompensieren sich die örtlichen und zeitlichen Phasendifferenzen, in Rückwärtsrichtung addieren sie sich zu 180°. Ein solcher Richtwandler kann sowohl als Sendewandler als auch als Empfangswandler verwendet werden und arbeitet in beiden Anwendungen fast verlustlos.

Der oben beschriebene bekannte Gruppen-Richtwandler (Fig. 2) ist mit zwei Mängeln behaftet:

1. Der ohm'sche Widerstand der weiteren Sammelschiene bzw. Erdleitung M verursacht Verluste und eine Verzerrung der Frequenzcharakteristik.

2. Ausgeprägte Nebenmaxima liegen im bzw. durchbrechen den Sperrbereich.

Die der Erfindung zugrundeliegende Aufgabe besteht darin, einen verlustarmen Wandler des Typs eines Richtwandlers anzugeben, der Planar (einschichtig) aufgebaut werden kann und ein ausgeprägtes Bandpassverhalten, nämlich ohne die für den bekannten Gruppen-Richtwandler typischen Nebenmaxima, aufweist. Diese Aufgabe wird mit dem Merkmal des Patentanspruches 1 gelöst und vorteilhafte Ausgestaltungen der Erfindung sind in weiteren Ansprüchen angegeben.

Der neue Richtwandler ist mit dem Gruppen-Richtwandler verwandt. Der Erfindung liegt die Erkenntnis zugrunde, daß innerhalb der Ausbrei-

2

tungsrichtung für die akustische Welle, d.h. quer zur Anordnung der Fingerelektroden, der eine Teilwandler ein- oder mehrmals von dem andersphasig betriebenen anderen Teilwandler unterbrochen wird. Eine wichtige Idee der vorliegenden Erfindung besteht darin, die Teilwandler der beiden Phasen möglichst vollständig und lückenlos vorliegen zu haben. Bei der Erfindung ist dazu vorgesehen, diese Teilwandler, bzw. deren Halbgruppen, auf vorgesehene zwei oder drei (oder noch mehr) Kanäle zu verteilen. Jeweils dort, wo ein Teilwandler, z. B. mit den Halbgruppen Ga1, Gb1,... in dem einen Kanal unterbrochen ist, um jeweils einer Halbgruppe (Ga2, Gb2, ...) des andersphasigen Teilwandlers Platz zu machen, wird dieser jeweils eine Teilwandler in einem anderen Kanal fortgesetzt und umgekehrt. Die Übertragungsfunktionen der einzelnen (bei der Erfindung mehreren) Kanäle haben zwar weiterhin die für Gruppen-Richtwandler typischen Nebenmaxima im Sperrbereich, aber bei der Summation der Wellen über alle Kanäle des erfindungsgemäßen Wandlers heben sich diese Maxima weitgehend bis vollständig auf. Der neue erfindungsgemäße Richtwandler funktioniert dann vollständig korrekt, wenn die ausgesandten akustischen Wellen über dessen ganze Apertur, d.h. über alle Kanäle des Wandlers, aufsummiert werden. Dies kann bekannterweise z. B. durch einen sog. Multistrip-Koppler oder durch einen nicht-überlappungsgewichteten konventionellen Wandler geschehen. Eine weitere Möglichkeit ist, zu einem erfindungsgemäßen Wandler mit der Anzahl k Kanälen (als z. B. Eingangswandler der Anordnung) eine Anzahl k Wandler (als z. B. Ausgangswandler) zu verwenden, die jedoch bekannte Wandler nach z. B. Fig. 2 (oder sogar bidirektionale Wandler) mit identischen Übertragungsfunktionen (und parallelgeschaltet) sind.

Bereits bei der erfindungsgemäßen Ausgestaltung mit zwei Kanälen ergeben sich - verglichen mit bekannten Gruppen-Richtwandlern, schon ganz wesentlich schwächere und schmalere Nebenmaxima. Sollen diese Nebenmaxima bei Verwendung von nur zwei Kanälen ganz unterdrückt werden, bieten sich zur Ausführung drei weitere Ausgestaltungen bzw. Möglichkeiten an:

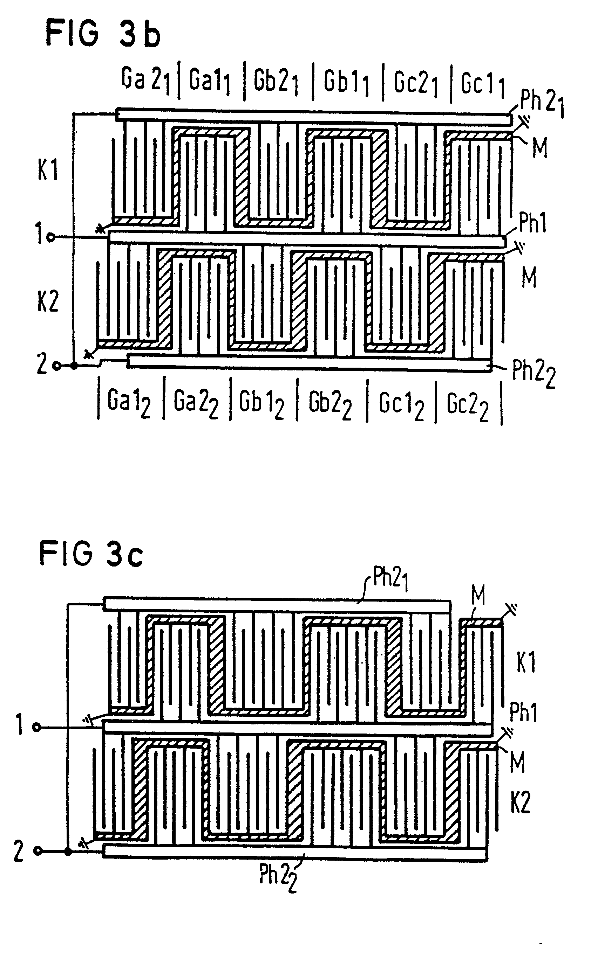

a) eine aperiodische Struktur der weiteren Sammelschiene bzw. Erdleitung M (Fig. 3c) und /oder

b) eine unterschiedliche Größe der Halbgruppen beim Sendewandler gegenüber dem Empfangswander (z. B. ein Wandler nach Fig. 3a und ein Wandler nach Fig. 3b), so daß sich die Nebenmaxima der beiden Wandler bei keiner Frequenz oder vergleichsweise erheblich seltener überlappen.

Diese beiden Maßnahmen a b werden auch bei konventionellen Gruppen-Richtwandlern angewandt. Diese Maßnahmen sind jedoch im Falle der Verwendung bei einem erfindungsgemäßen Wandler bedeutet effizienter, da die zu verhindernden Rest-Nebenmaxima nur klein sind.

Eine dritte Maßnahme ist

c) einen erfindungsgemäßen Wandler mit dementsprechend mehreren Kanälen nach dem an sich bekannten Splitfinger-Prinzip auszugestalten, d.h. lediglich die oben erwähnten einzelnen Fingerelektroden als Splitfingerelektroden auszuführen, wobei anstelle jeweils einer Fingerelektrode (mit der Breite und mit dem Zwischenraum je Lambda/4) zwei gleichgepolte (parallele) Fingerelektroden vorgesehen sind (mit Breite und Fingerzwischenraum Lambda/8). Eine Splitfinger-Ausführung der Erfindung liefert im übrigen schon bei nur zwei Kanälen fast optimales Ergebnis und kann insbesondere bereits mit lückenloser Plazierung der Fingerelektroden ausgeführt werden.

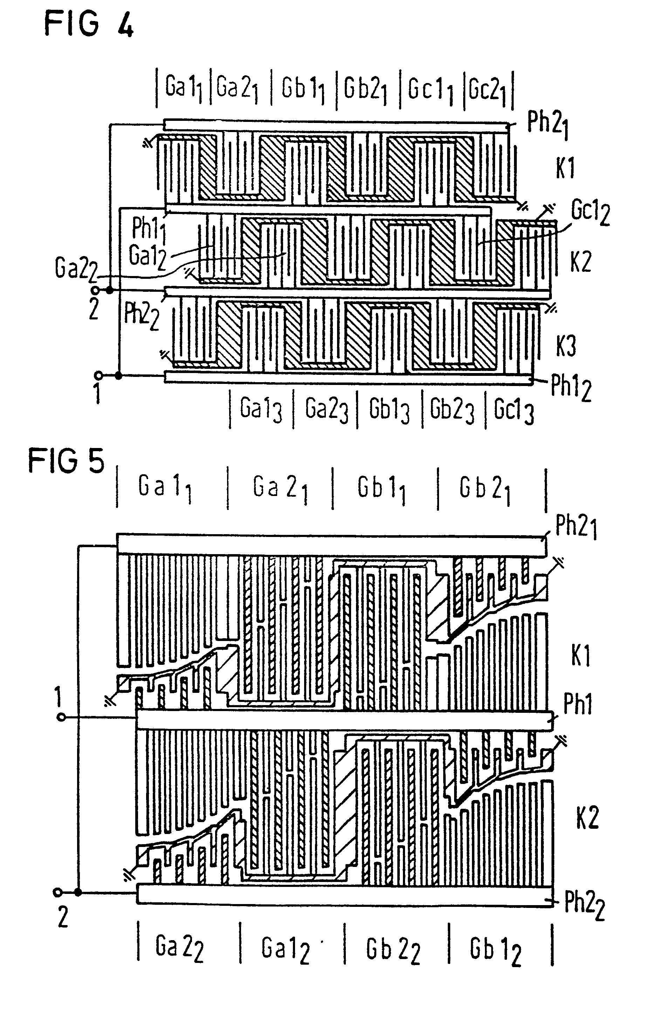

Bei nach der Erfindung drei oder mehr Kanälen verschwinden die für bekannte Gruppen-Richtwandler typischen Nebenmaxima ohne die Maßnahmen nach a und b, da bei einer solchen Anzahl von Kanälen die Fingerelektroden beider Teilwandler völlig lückenlos plaziert werden können. Für jede Phase Ph1 und Ph2 ist pro Wellenlängenabmessung Lambda mindestens ein "heißer" Finger (mit einer der Sammelschienen Ph1 bzw. Ph2 verbunden) und ein mit der weiteren Sammelschiene M verbundener "kalter" Finger vorhanden. Dabei können bei drei Kanälen trotz lückenloser Plazierung der Fingerelektroden die den Fingerelektroden parallellaufenden Anteile der weiteren Sammelschiene M verbreitert werden, wie dies die Fig. 4 zeigt.

Nebst der Unterdrückung der Nebenmaxima hat der neue Wandler den Vorteil, daß der störende ohm'sche Widerstand der weiteren Sammelschiene bzw. Erdleitung M aus folgenden Gründen stark vermindert werden kann:

1. Die weiteren Sammelschienen (Erdleitungen) M der einzelnen Kanäle können (wie die Figuren zeigen) parallelgeschaltet werden. Demzufolge reduziert sich der resultierende Widerstand. Ferner kann man (aus Impedanz- und Platzgründen und ohne Nachteil) die Apertur (Breite) der einzelnen Kanäle kleiner wählen als beim herkömmlichen Entwurf mit nur einem Kanal, so daß sich der ohm'sche Widerstand weiter reduzieren läßt.

2. Beim konventionellen Gruppen-Richtwandler muß die Anzahl der Fingerelektroden pro Halbgruppe klein sein, damit die (Frequenz-) Abstände der Nebenmaxima möglichst groß werden. Beim neuen erfindungsgemäßen Richtwandler besteht diese Einschränkung nicht. Es sind größere Gruppen zulässig, so daß die weitere Sammelschiene bzw. Erdleitung M weniger häufig mäandriert, daher kürzer wird und dementsprechend niederohmiger ist.

3. Beim neuen Wandler besteht (zumindest bei drei oder mehr Kanälen) zwischen den Halbgruppen genügend Platz für eine starke Verbreiterung

5

(der jeweils parallel den Fingern verlaufenden Anteile) der weiteren Sammelschienen bzw. Erdleitungen M, so daß der elektrische Widerstand weiter verkleinert werden kann.

Die vorstehenden Ausführungen werden nun anhand einiger Figuren näher erläutert. Die dargestellten Wandlerstrukturen wurden aus Gründen
der Übersichtlichkeit schematisiert, insbesondere
sind die Maßstäbe in x- und y-Richtung verschieden.

Fig. 1   zeigt eine isometrische Darstellung einer
        Oberflächenanordnung mit zwei Interdigital-Wandlern.
Fig. 2   zeigt einen bekannten Gruppen-Richtwandler.

Die Figuren 3a bis c zeigen Ausführungsformen
eines erfindungsgemäßen Wandlers mit zwei Kanälen.

Fig. 4   zeigt einen erfindungsgemäßen Wandler
        mit drei Kanälen.
Fig. 5   zeigt einen erfindungsgemäßen Wandler
        in der Ausführung mit an sich bekannter
        Finger-Überlappungswichtung.
Fig. 6   zeigt ein SAW-Filter mit zwei erfindungs-
        gemäßen Wandlern (mit Fingerwi-
        chtung), zwischen denen ein Multistrip-
        Koppler angeordnet ist.
Fig. 7   zeigt einen der Fig. 3b entsprechenden
        Wandler mit Fingerlücke und
Fig. 8   zeigt einen erfindungsgemäßen Wandler
        in Splitfingerausführung.

Fig 1 zeigt ein SAW-Filter mit einem piezoelektrischen Kristall bzw. Substrat Sb und bidirektionalen Sende- und Empfangswandlern.

In Fig. 2 ist die Struktur eines bekannten
Gruppen-Richtwandlers mit drei Gruppen Ga, Gb
und Gc dargestellt. Die Gruppe Ga besteht aus
den Halbgruppen Ga1 und Ga2. Die Gruppe Gb
besteht aus den Halbgruppen Gb1 und Gb2 usw.
Der eine Teilwandler mit der Sammelschiene Ph1
umfaßt somit die Halbgruppen Ga1, Gb1 und
Gc1. Der andersphasig gespeiste Teilwandler mit
der Sammelschiene Ph2 umfaßt die Halbgruppen
Ga2, Gb2 und Gc2. Die weitere Sammelschiene
bzw. Erdleitung M ist schraffiert hervorgehoben
dargestellt.

Fig. 3a zeigt das Schema eines erfindungsgemäßen Richtwandlers mit zwei Kanälen K1 und
K2. In jedem Kanal sind 6 Halbgruppen vorgesehen und zwar Ga1₁, Ga2₁, Gb1₁, Gb2₁, Gc1₁,
Gc2₁ im Kanal K1 und Ga2₂, Ga1₂, Gb2₂, Gb1₂,
Gc2₂, Gc1₂ im Kanal K2. In jedem Kanal sind die
jeweils 6 Halbgruppen mit je 2 "heißen" Fingerelektroden aneinandergereiht, die je nach Phasenlage 1 od. 2 entweder mit der mittleren Sammelschiene Ph1 oder mit einer der beiden äußeren (parallelgeschalteten) Sammelschienen Ph2₁,
Ph2₂ verbunden sind. Die "heißen" Fingerelektroden müssen für die jeweilige Phase 1, 2 auf einem Raster mit dem Linienabstand w liegen, wo-

6

bei w die akustische Wellenlänge Lambda bei
der Synchron- oder Mittenfrequenz ist. Kleine Abweichungen von diesem Raster bis zu ±w/10 sind
möglich. Falls Doppel- bzw. Splitfingerelektroden
verwendet werden, muß sinngemäß die Mitte der
jeweils beiden (auf jeweils gleichem Potential liegenden) Fingerelektroden auf dem jeweiligen Raster liegen.

Der in Fig. 3a dargestellte erfindungsgemäße
Wandler hat bezüglich der Phase 2 (mit den
Sammelschienen Ph2₁ oder Ph2₂ verbunden)
insgesamt 12 "heiße" Fingerelektroden und dabei
nur zwei Lücken (2.w) von nur je einer Fingerelektrode, d.h. es fehlt dort nur eine Fingerelektrode. Bei einem Richtwandler mit nur einem Kanal (siehe Fig. 2) wären es Lücken von je 3 Fingerelektroden. Die beiden Raster (für jeden Teilwandler bzw. jede Phase 1 und 2 jeweils einen
Raster) sind um eine Viertel Wellenlänge, d.h. um
w/4 wie angegeben, gegeneinander verschoben
anzuordnen.

Fig. 3b zeigt einen Wandler mit je 3 "heißen"
Fingerelektroden je Halbgruppe Ga1₁, Ga2₂,
Ga2₁, Ga1₂,..., Gb1₁..... .

Die Anzahl der Gruppen Ga, Gb, Gc,... wie
auch die Anzahl der Fingerelektroden pro Halbgruppe Ga1₁, Ga2₁,... kann je nach gewünschter
Wandlercharakteristik stark von den in Figuren 3
bis 8 dargestellten Beispielen abweichen. Insbesondere kann die Anzahl der Fingerelektroden
pro Halbgruppe innerhalb eines Wandlers variieren, z. B. um bei einer 2-Kanal-Ausführung eines
erfindungsgemäßen Wandlers die Rest-Nebenmaxima zu unterdrücken. Ein solcher Wandler ist
in Fig. 3c dargestellt. Die Sequenz bzw. die Fingeranzahl der "heißen" Fingerelektroden ist in
beiden Kanälen die folgende: 2, 3, 4, 4, 3, 2. Um
eine gute Richtwirkung auch dann zu erzielen,
wenn Halbgruppen mit relativ großer Fingerelektrodenanzahl verwendet werden (dies vermindert den ohm'schen Widerstand der weiteren
Sammelschiene M) ist es günstig, die Größe der
Gruppen zu den Enden des Wandlers hin etwas
zu verkleinern, nämlich wie beim Zahlenbeispiel
der Fig. 3c. Besonders geringen wirksamen
ohm'schen Widerstand erhält man jedoch bei größerer Fingeranzahl der Halbgruppen an den Enden, nämlich bei dort weniger häufigem Meandrieren der weiteren Sammelschiene M. Es empfielt sich ein Abwägen der jeweiligen Vorteile
gegeneinander.

Fig. 4 zeigt einen (ebenfalls) ungewichteten,
erfindungsgemäßen Richtwandler mit drei Kanälen. Hier besitzen die beiden Phasen 1 und 2
über alle drei Kanäle K1 - K3 betrachtet - eine mit
Abständen Lambda bzw. w lückenlose Reihe
"heißer" Fingerelektroden. Falls wie in Fig. 4 je
drei "heiße" Fingerelektroden pro Halbgruppe gewählt wurden, besteht zwischen den Halbgruppen Platz für die jeweilige weitere Sammelschiene M mit einer Breite des 1 bzw. 1,5-fachen der
Wellenlänge Lambda bzw. der Abmessung w. Bei
einem Wandler mit nur zwei Kanälen (Fig. 3a bis
3c) ergeben sich, sofern eine solche Breite der
Sammelschiene M vorgegeben wird, zusätzliche Lücken. Dies kann im Einzelfall jedoch sogar von Vorteil sein, nämlich weil sich damit im Wandler eine Periodizität mit verdoppelter Frequenz ergibt, die die relativen Abstände der Nebenmaxima vergrößert.

Fig. 5 zeigt ein Beispiel eines überlappungsgewichteten neuen Richtwandlers mit wiederum zwei Kanälen. Die (an sich bekannte) Überlappungswichtung wird - wie bei konventionellen Wandlern - dazu verwendet, die generelle Sperrselektion eines Filters zu erhöhen. Üblicherweise wird die Wichtung ungefähr symmetrisch bezüglich der Wandermitte ausgeführt. Die in Fig. 5 gezeigte Wichtung, bei der die kleinsten Überlappungen (innerhalb eines Kanals) an diametral gegenüberliegenden Ecken vorkommen, hat folgende Vorteile:

1. Eine gleichmäßige Verteilung der akustischen Energie über die gesamte Apertur des Kanals.

2. Bei Verwendung einer geeigneten (vorgegebenen) Wichtungsfunktion sind über die ganze Wandlerapertur die Teilwellen jeder Phase gleich stark (d.h. es sind von beiden Phasen stets gleich viele Fingerelektroden an der Erzeugung bzw. Detektion der akustischen Wellen beteiligt.) Dies verbessert die Richtwirkung des Wandlers.

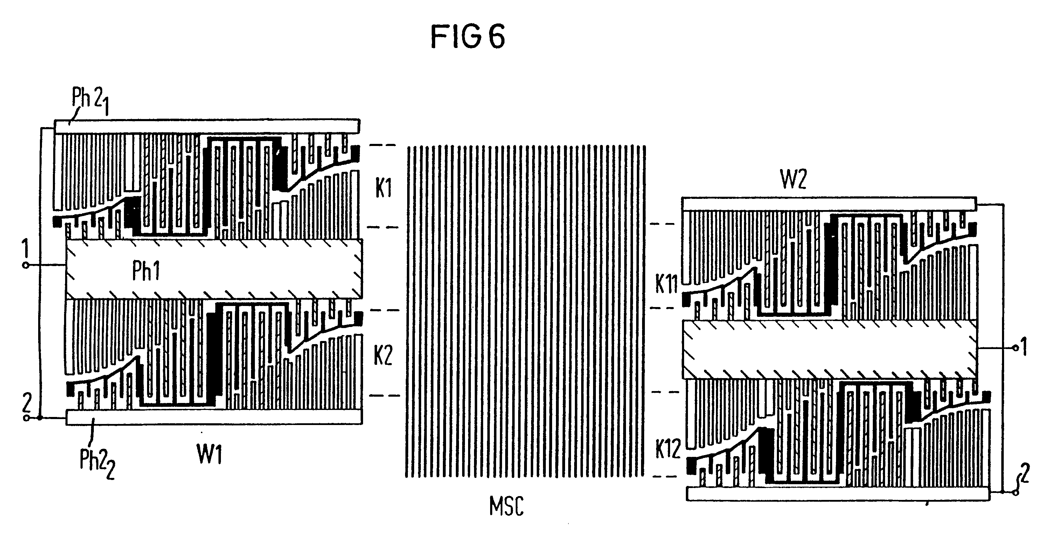

Fig. 6 zeigt ein SAW-Filter mit zwei überlappungsgewichteten erfindungsgemäßen Wandlern und einem Multistrip-Koppler MSC. Der Multistrip-Koppler besteht aus einer Anzahl paralleler Streifen und hat (in dieser Anwendung) die Aufgabe, die vom Sendewandler W1 auf den Kanälen K1 und K2 einfallenden Wellen aufzusummieren und auf den Kanälen K11 und K12 an den Empfangswandler zu schicken. Durch die Anwendung des Multistrip-Kopplers können Sende- und Empfangswandler nach dem neuen Prinzip aufgebaut werden. Ein Versatz für den Eingangswandler gegenüber den Ausgangswandler ist für einen Multistrip-Koppler an sich üblich. In Fig. 6 ist jedoch ein für die Erfindung besonderer Versatz vorgesehen mit wie dargestellter Verschachtelung der Kanäle K1, K2 einerseits und mit den Kanälen K11 und K12 andererseits.

Fig. 7 zeigt eine noch weitere Ausgestaltung eines der Fig. 3b entsprechenden Wandlers. Es sind dort in den Halbgruppen des einen Teilwandlers in periodischer Anordnung bzw. Folge jeweils eine Fingerelektrode (pro Halbgruppe) als aktive Fingerelektrode weggelassen, vorzugsweise ist diese Fingerelektrode als (nicht aktiver) Blindfinger ausgebildet. In der Halbgruppe $Ga1_1$ ist, damit das Weglassen einer aktiven Fingerelektrode ebenfalls dargestellt ist, ein solcher Finger weggelassen. Das gleiche ist für die Halbgruppen des anderen dieser beiden Teilwandler vorgesehen und zwar wieder periodisch für diesen Teilwandler. Die Periode des einen Teilwandlers ist gegenüber der Periode des anderen Teilwanders um Lambda/4 versetzt, wie dies dem gegenseitigen Versatz der Teilwandler entspricht. Eine solche Fingerweglassung bzw. Ausbildung eines solchen Fingers als nicht aktiven Blindfinger dient dazu, dem Wandler eine weitere bzw. andere Periodizität aufzuprägen.

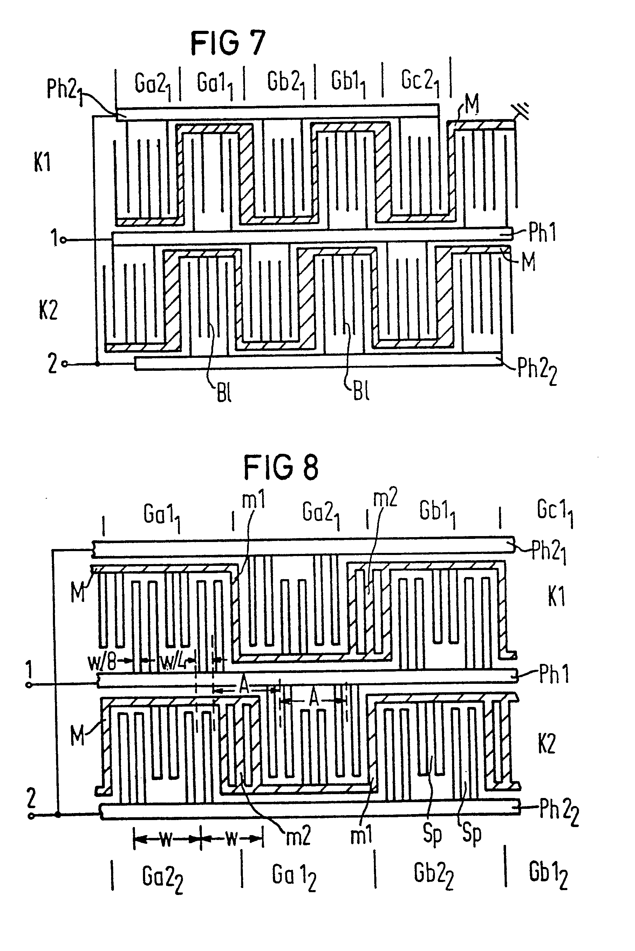

Die Fig. 8 zeigt eine Splitfinger-Ausführung, der Einfachheit halber wiederum für lediglich zwei Kanäle, wobei allerdings die Anwendung von Splitfingern bereits bei zwei Kanälen schon fast optimales Ergebnis erzielen läßt. Die einzelnen Splitfinger-Elektroden sind mit Sp bezeichnet.

Schon bei 2-Kanal-Ausführung erreicht man lückenlose Verteilung der Fingerelektroden, wenn man - wie Fig. 8 zeigt - an einzelnen Stellen jeweils denjenigen Anteil der weiteren Sammelschiene M, der parallel den übrigen Fingerelektroden verläuft, so ausführt, das dieser Anteil die Form bzw. Breite eines einzelnen Fingers m1 eines Splitfingerpaares hat oder aus drei nebeneinander liegenden solchen einzelnen Fingern m2 besteht. Die beiden zwischen solchen drei nebeneinander liegenden "Fingern" vorhandenen Zwischenräume können auch ausgefüllt sein. Dies würde jedoch eine kleine Unregelmäßigkeit für die Wellenfortpflanzung im Wandler ergeben.

## Patentansprüche

1. Wandler für SAW-Filter, ausgeführt als Gruppen-Richtwandler, auf einem Substrat, für den Betrieb mit zwei Phasen (1, 2) und Bezugspotential, mit in einem Kanal K angeordneten Strukturen mit ersten Fingerelektroden, die jeweils mit einer von mehreren vorhandenen Sammelschienen Ph1, Ph2 verbunden sind und mit einer zwischen zwei dieser Sammelschienen Ph1, Ph2 eingefügten weiteren mäanderförmigen Sammelschiene M, zu der weitere Fingerelektroden gehören, wobei die ersten Fingerelektroden einerseits und die Fingerelektroden der weiteren Sammelschiene M andererseits interdigital derart ineinander greifen, so daß einen ersten Teilwandler bildende erste Halbgruppen (Ga1, Gb1, Gc1,...) für eine erste Phase 1 und einen zweiten Teilwandler bildende zweite Halbgruppen (Ga2, Gb2, Gc2,....) für die zweite Phase 2 vorliegen und wobei Halbgruppen des einen Teilwandlers mit Halbgruppen des anderen Teilwandlers alternierend verschachtelt und mit Phasenverschiebung ± Lambda/4 zwischen den Teilwandlern angeordnet sind, *gekennzeichnet dadurch,*

- daß die ersten Halbgruppen ($Ga1_1$, $Gb1_1$,....; $Ga1_2$, $Gb1_2$, ...) des einen Teilwandlers und die zweiten Halbgruppen ($Ga2_1$, $Gb2_1$...; $Ga2_2$, $Gb2_2$...) des anderen Teilwandlers auf zwei oder mehr, parallel angeordnete Kanäle (K1, K2...) des Wandlers derart aufgeteilt sind,

- daß jeweils dort, wo in einem Kanal (K1) die Folge der Halbgruppen (Ga1, Gb1 ...) des einen Teilwandlers durch Halbgruppen (Ga2, Gb2 ...) des anderen andersphasigen Teilwandlers unterbrochen ist, dieser eine Teilwandler versetzt in einen anderen Kanal (K2, K3) fortgeführt ist,

9

— so daß für alle Kanäle (K1, K2,...) des Wandlers zusammengenommen betrachtet sich fortlaufend über die Länge L des Wandlers sowohl erste Halbgruppen (Ga1, Gb1,...) des einen Teilwandlers als auch zweite Halbgruppen (Ga2, Gb2,...) des anderen Teilwandlers erstrecken.

2. Wandler nach Anspruch 1 gekennzeichnet dadurch, daß die Halbgruppen (Ga1, Gb1,...) (Ga2, Gb2,...) der beiden Teilwandler regelmäßig abwechselnd zyklisch auf alle Wandlerkanäle (K1, K2,...) verteilt sind (Fig. 3a bis 3c; Fig. 4)

3. Wandler nach Anspruch 1 oder 2 gekennzeichnet *dadurch* daß die Fingerelektroden als Splitfingerelektroden (Sp) (Fig. 8) ausgebildet sind.

4. Wandler nach Anspruch 1, 2 oder 3 gekennzeichnet dadurch, daß für jeweils den einen und den anderen Teilwandler (Ga1, Gb1,... bzw. Ga2, Gb2,...) der (in Ausbreitungsrichtung der Welle) laterale Mitten-Abstand (A) der "heißen" Fingerelektroden des jeweils einen Teilwandlers, die mit einer der Sammelschienen (Ph1; Ph1₁, Ph1₂ bzw. Ph2₁, Ph2₂) verbunden sind die jeweils an die eine oder an die andere Phase (1 oder 2) anzuschließen ist, (gleichphasige Fingerelektroden) eine Größe von mindestens zwei Fingerelektroden-Breiten (= Lambda) hat, so daß höchstens lückenlose Verteilung dieser "heißen" Fingerelektroden vorliegt. (Fig. 3a, Fig. 8)

5. Wandler nach Anspruch 1, 2 od. 3 gekennzeichnet dadurch daß für den einen Teilwandler (Ga1, Ga2,... bzw. Ga2, Gb2,...) mindestens einmal zwei "heiße", mit einer Sammelschiene (Ph1; Ph1₁, Ph1₂ bzw. Ph2₁, Ph2₂) verbundene, jedoch in zwei verschiedenen Kanälen (K1, K2,...) vorhandene Fingerelektroden bzw. Splitfinger Elektroden auf einer gemeinsamen (fiktiven) Geraden, senkrecht zur Wellenausbreitungsrichtung des Wandlers orientiert, liegen.

6. Wandler nach einem der Ansprüche 1 bis 5 gekennzeichnet dadurch, daß mindestens bei einem der Teilwandler (Ga1, Gb1,... bzw. Ga2, Gb2,...) die Anzahl "heißer" Fingerelektroden, die mit einer, an eine der Phasen (1 oder 2) anzuschließende Sammelschiene (Ph1; Ph1₁ Ph1₂ bzw. Ph2₁, Ph2₂) verbunden sind, pro Halbgruppe (Ga1, Gb1, Gc1,... bzw. Ga2, Gb2, Gc2,...) dieses Teilwandlers nicht-konstant ist (Fig. 3c).

7. Wandler nach Anspruch 6 gekennzeichnet dadurch daß die jeweilige Anzahl dieser "heißen" Fingerelektroden gegen die Wandlerenden hin abnehmend ist (Fig. 3c).

8. Wandler nach Anspruch 6 gekennzeichnet *dadurch* daß die Anzahl dieser "heißen" Fingerelektroden gegen die Wandlerenden hin zunehmend ist.

10

9. Wandler nach einem der Ansprüche 1 bis 8 gekennzeichnet dadurch, daß dieser Wandler (Fig. 5) eine Überlappungswichtung derart aufweist, das innerhalb eines jeden Kanals (K1, K2) über mindestens 80 % der Apertur die Anzahl aktiver Fingerüberlappungen für eine jede Phase (1, 2) um höchstens ± 25 % schwankt.

10. Wandler nach einem der Ansprüche 1 bis 9 gekennzeichnet dadurch daß wenigstens im wesentlichen in allen Halbgruppen (Ga1, Gb1, Gc1,... und Ga2, Gb2, Gc2,...) periodisch, jeweils auf die Halbgruppen (Ga1, Gb1, Gc1,... oder Ga2, Gb2, Gc2,...) desselben Teilwandlers bezogen, jeweils eine Fingerelektrode weggelassen, bzw. diese als Blindfinger ausgebildet ist, wobei die Periodizität des einen Teilwandlers und die des anderen Teilwandlers entsprechend dem Versatz (Lambda/4) dieser Teilwandler gegeneinander ebenfalls diesen Versatz (Lamda/4) gegeneinander haben.

11. SAW-Filter (Fig. 6) mit zwei nach einem der Ansprüche 1 bis 10 ausgebildeten Wandlern (W1, W2) und mit einem dazwischen angeordneten Multistrip-Koppler (MSC) wobei bei diesem Filter zwischen zwei benachbarten Kanälen (K1, K2,...) des einen Wandlers (W1) ein Kanal (K11...) des anderen Wandlers (W2) liegt.

**Claims**

1. Transducer for SAW filter constructed as group-type unidirectional transducer on a substrate for operation with two phases (1, 2) and reference potential, having structures arranged in one channel K and comprising first finger electrodes which are each connected to one of a plurality of available busbars ph1, ph2 and having a further meander-type busbar M which is inserted between two of these busbars ph1, ph2 and to which further finger electrodes belong, the first finger electrodes, on the one hand, and the finger electrodes of the further busbar M, on the other hand, enmeshing interdigitally in a manner such that first half-groups (Ga1, Gb1, Gc1, ...) forming a first subtransducer for a first phase 1 and second half-groups (Ga2, Gb2, Gc2,...) forming a second subtransducer for the second phase 2 are present, halfgroups of one subtransducer being alternatingly interlaced with half-groups of the other subtransducer and being arranged with a phase shift of ± λ/4 between the subtransducers, characterized in that the first halfgroups (Ga1₁, Gb1₁,...; Ga1₂, Gb1₂,...) of one subtransducer and the second half-groups (Ga2₁, Gb2₁ ...; Ga2₂, Gb2₂...) of the other subtransducer are split up into two or more channels (K1, K2...), arranged in parallel, of the transducer in a manner such that whenever the sequence of the halfgroups (Ga1, Gb1...) of one subtransducer in one channel (K1) is interrupted by half-groups (Ga2, Gb2 ...) of the other different-phase subtransducer, this one subtransducer is continued in a staggered manner in another channel (K2, K3) so that, for all the channels (K1, K2,...) of the transducer considered in combination, both first half-groups (Ga1, Gb1,...) of one subtransducer and also second half-groups (Ga2, Gb2, ...) of the other subtransducer extend over the length L of the transducer.

2. Transducer according to Claim 1, characterized in that the half-groups (Ga1, Gb1, ...), (Ga2, Gb2,...) of the two subtransducers are regularly distributed in an alternatingly cyclic manner over all the transducer channels (K1, K2,...) (Figures 3a to 3c; Figure 4).

3. Transducer according to Claim 1 or 2, characterized in that the finger electrodes are constructed as split finger electrodes (Sp) (Figure 8).

4. Transducer according to Claim 1, 2 or 3, characterized in that, for one subtransducer and the other subtransducer respectively (Ga1, Gb1, ... and Ga2, Gb2, ... respectively), the lateral centre-to-centre spacing (A) (in direction of propagation of the wave) of the "hot" finger electrodes of each subtransducer which are connected to one of the busbars (Ph1; Ph1₁, Ph1₂ or Ph2₁, Ph2₂ respectively) which is to be connected to one phase or the other (1 or 2) in each case (co-phasal finger electrodes), has a size of at least two finger electrode widths (= λ) so that at most there is uninterrupted distribution of said "hot" finger electrodes (Figure 3a, Figure 8).

5. Transducer according to Claim 1, 2 or 3, characterized in that, for one subtransducer (Ga1, Ga2,... or Ga2, Gb2,...), two "hot" finger electrodes or split finger electrodes connected to one busbar (Ph1; Ph1₁, Ph1₂ or Ph2₁, Ph2₂ respectively) but present in two different channels (K1, K2,...) are situated at least once on a common (imaginary) straight line oriented perpendicular to the wave propagation direction of the transducer.

6. Transducer according to one of Claims 1 to 5, characterized in that, at least in the case of one of the subtransducers (Ga1, Gb1,.., or Ga2, Gb2,... respectively), the number of "hot" finger electrodes which are connected with one busbar (Ph1; Ph1₁, Ph1₂ or Ph2₁, Ph2₂ respectively) which is to be connected to one of the phases (1 or 2) is not constant for each half-group (Ga1, Gb1, Gc1,... or Ga2, Gb2, Gc2,... respectively) of this subtransducer (Figure 3c).

7. Transducer according to Claim 6, characterized in that the respective number of said "hot" finger electrodes decreases towards the ends of the transducer (Figure 3c).

8. Transducer according to Claim 6, characterized in that the number of said "hot" finger electrodes increases towards the ends of the transducer.

9. Transducer according to one of Claims 1 to 8, characterized in that said transducer (Figure 5) has an overlap weighing such that, within each channel (K1, K2) the number of active finger overlaps varies by not more than ± 25 % over at least 80 % of the aperture for each phase (1, 2).

10. Transducer according to one of Claims 1 to 9, characterized in that, at least essentially in all the half-groups (Ga1, Gb1, Gc1,... and Ga2, Gb2, Gc2,...), in each case one finger electrode is periodically omitted, or constructed as blind finger, referred in each case to the half-groups (Ga1, Gb1, Gc1,... or Ga2, Gb2, Gc2,...) of the same subtransducer, the periodicity of one subtransducer and that of the other subtransducer corresponding to the staggering (λ/4) of these subtransducers with respect to each other also having said staggering (λ/4) with respect to each other.

11. SAW filter (Figure 6) having two transducers (W1, W2) constructed according to one of Claims 1 to 10 and having a multistrip coupler (MSC) between them, and in this filter there is situated between two adjacent channels (K1, K2,...) of one transducer (W1) a channel (K11...) of the other transducer (W2).

**Revendications**

1. Transducteur pour filtres SAW, réalisé sous la forme d'un transducteur directionnel de groupe, sur un substrat, pour le fonctionnement avec deux phases (1, 2) et un potentiel de référence, comportant des structures disposées dans un canal K et possédant des premières électrodes en forme de doigts, qui sont reliées respectivement à l'une de plusieurs barres omnibus existantes Ph1, Ph2, et une autre barre omnibus en forme de méandres M, qui est insérée entre ces deux barres omnibus Ph1, Ph2 et dont font partie d'autres électrodes en forme de doigts, et dans lequel les premières électrodes en forme de doigts d'une part et les électrodes en forme de doigts de l'autre barre omnibus M d'autre part s'interpénètrent d'une manière interdigitée pour former des premiers demi-groupes (Ga1, Gb1, Gc1...), formant un premier transducteur partiel, pour une première phase 1 et des seconds demi-groupes (Ga2, Gb2, Gc2,...) formant des seconds transducteurs partiels, pour la seconde phase 2, et des demi-groupes d'un transducteur partiel sont imbriqués de façon alternée avec des demi-groupes de l'autre transducteur partiel et il existe un déphasage plus ou moins lambda/4 entre les transducteurs partiels, caractérisé par le fait

- que les premiers demi-groupes (Ga1₁, Gb1₁,...; Ga1₂, Gb1₂,...) du premier transducteur partiel et les seconds demi-groupes (Ga2₁, Gb2₁,...Ga2₂, Gb2₂...) de l'autre transducteur partiel sont répartis entre deux ou plusieurs canaux parallèles (K1, K2...) du transducteur de telle sorte qu'à l'endroit où, dans un canal (K1), la suite des demi-groupes (Ga1, Gb1...) d'un transducteur partiel est interrompue par des demi-groupes (Ga2, Gb2...) de l'autre transducteur partiel, qui est relié à l'autre phase, le premier transducteur partiel se prolonge d'une manière décalée dans un autre canal (K2, K3),

– de sorte que, d'une manière considérée globalement pour tous les canaux (K1, K2...) du transducteur, aussi bien des premiers demi-groupes (Ga1, Gb1...) d'un transducteur partiel que des seconds demi-groupes (Ga2, Gb2,...) de l'autre transducteur partiel s'étendent de façon continue sur la longueur L du transducteur.

2. Transducteur suivant la revendication 1, caractérisé par le fait que les demi-groupes (Ga1, Gb1,...) (Ga2, Gb2,...) des deux transducteurs partiels sont répartis d'une manière régulière alternée et cyclique entre tous les canaux (K1, K2,...) du transducteur (figures 3a à 3c; figure 4).

3. Transducteur suivant la revendication 1 ou 2, caractérisé par le fait que les électrodes en forme de doigts sont réalisées sous la forme d'électrodes en forme de doigts divisés (Sp) (figure 8).

4. Transducteur suivant la revendication 1, 2 ou 3, caractérisé par le fait que respectivement pour l'un et l'autre des transducteurs partiels (Ga1, Gb1,... ou Ga2, Gb2,...), la distance latérale (dans la direction de propagation de l'onde) (A) entre les centres des électrodes "chaudes" en forme de doigts d'un transducteur partiel respectif, qui sont reliées à l'une des barres omnibus (Ph1; Ph1$_1$, Ph1$_2$ ou Ph2$_1$, Ph2$_2$), qui doit être raccordée respectivement à une phase ou à l'autre phase (1 ou 2), (électrodes en forme de doigts d'une même phase), possède une valeur égale à au moins deux largeurs d'électrodes en forme de doigts (≈ lambda), de sorte qu'on obtient une répartition, présentant aussi peu de discontinuités que possible, de ces électrodes "chaudes" en forme de doigts. (figure 3a, figure 8).

5. Transducteur suivant la revendication 1, 2 ou 3, caractérisé par le fait que pour un transducteur partiel (Ga1, Ga2,... ou Ga2, Gb2,...), au moins deux électrodes en forme de doigts ou électrodes "chaudes" en forme de doigts subdivisés, reliées à une barre omnibus (Ph1; Ph1$_1$, Ph1$_2$ ou Ph2$_1$, Ph2$_2$), mais présentes dans deux canaux différents (K1, K2,...), sont situées sur une droite (fictive) commune, perpendiculaire à la direction de propagation des ondes du transducteur.

6. Transducteur suivant l'une des revendications 1 à 5, caractérisé par le fait qu'on moins dans le cas de l'un des transducteurs partiels (Ga1, Gb1,... ou Ga2, Gb2,...), le nombre d'électrodes "chaudes" en forme de doigts, qui sont reliées à une barre omnibus (Ph1, Ph1$_1$, Ph1$_2$ ou Ph2$_1$, Ph2$_2$), devant être raccordée à l'une des phases (1 ou 2), n'est pas constant dans chaque demi-groupe (Ga1, Gb1, Gc1,... ou Ga2, Gb2, Gc2,...) de ce transducteur partiel (figure 3c).

7. Transducteur suivant la revendication 6, caractérisé par le fait qui le nombre respectif de ces électrodes "chaudes" en forme de doigts diminue en direction des extrémités du transducteur (figure 3c).

8. Transducteur suivant la revendication 6, caractérisé par le fait que le nombre de ces électrodes en forme de doigts "chaudes" augmente en direction des extrémités du transducteur.

9. Transducteur suivant l'une des revendications 1 à 8, caractérisé par le fait que ce transducteur (figure 5) comporte une pondération par chevauchement de sorte qu'à l'intérieur de chaque canal (K1, K2), sur au moins 80 % de l'ouverture, le nombre de chevauchement actifs de doigts pour chaque phase (1, 2) varie au maximum de ±25 %.

10. Transducteur suivant l'une des revendications 1 à 9, caractérisé par le fait qu'au moins essentiellement dans tous les demi-groupes (Ga1, Gb1, Gc1,... et Ga2, Gb2, Gc2,...), une électrode respective en forme de doigt est supprimée périodiquement, et ce en rapport avec les demi-groupes (Ga1, Gb1, Gc1,... ou Ga2, Gb2, Gc2,...) du même transducteur partiel, ou que cette électrode en forme de doigt est réalisée sous la forme d'un doigt aveugle, les périodicités d'un transducteur partiel et de l'autre transducteur partiel, qui sont séparées par le décalage (lambda/4), étant décalées l'une par rapport à l'autre de ce même décalage (lambda/4).

11. Filtre SAW (figure 6) comportant deux transducteurs (W1, W2) réalisés selon l'une des revendications 1 à 10 et comportant un coupleur multibandes (MSC) inséré entre ces transducteurs, et dans lequel entre deux canaux voisins (K1, K2,...) d'un transducteur (W1) se trouve disposé un canal (K11...) de l'autre transducteur (W2).

FIG 1

FIG 2

FIG 3a

## FIG 3b

| Ga2₁ | Ga1₁ | Gb2₁ | Gb1₁ | Gc2₁ | Gc1₁ |

$Ph2_1$

$M$

$K1$

$1$

$Ph1$

$M$

$K2$

$2$

$Ph2_2$

| Ga1₂ | Ga2₂ | Gb1₂ | Gb2₂ | Gc1₂ | Gc2₂ |

## FIG 3c

$Ph2_1$

$M$

$K1$

$Ph1$

$1$

$M$

$2$

$K2$

$Ph2_2$

# FIG 4

# FIG 5

FIG 6

# FIG 7

# FIG 8